## Europäisches Patentamt

## European Patent Office

## Office européen des brevets

(19)

(11) Veröffentlichungsnummer: **0 065 649**

**A1**

(12)

# EUROPÄISCHE PATENTANMELDUNG

(21) Anmeldenummer: **82103406.3**

(22) Anmeldetag: **22.04.82**

(51) Int. Cl.³: **H 03 K 17/945**
**H 03 B 5/06**

(30) Priorität: **26.05.81 DE 3120884**

(43) Veröffentlichungstag der Anmeldung:
**01.12.82 Patentblatt 82/48**

(84) Benannte Vertragsstaaten:
**AT BE CH FR GB IT LI LU NL SE**

(71) Anmelder: **i f m electronic gmbh**
**Teichstrasse 4**
**D-4300 Essen 1(DE)**

(72) Erfinder: **Friedrich, Michael Burkhard**
**Rosenstrasse 10**
**D-7993 Kressbronn(DE)**

(72) Erfinder: **Czech, Ingo Sigurd**
**Stettiner Strasse 13**
**D-7990 Friedrichshafen 1(DE)**

(74) Vertreter: **Gesthuysen, Hans Dieter, Dipl.-Ing. et al,**
**Patentanwälte Gesthuysen + von Rohr Huyssenallee 15**
**Postfach 10 13 33**
**D-4300 Essen 1(DE)**

(54) **Elektronisches, berührungslos arbeitendes Schaltgerät.**

(57) Dargestellt und beschrieben ist ein elektronisches, berührungslos arbeitendes Schaltgerät (1), mit einem von außen beeinflußbaren Oszillator (10), einem Schaltverstärker (11), einem von dem Oszillator (10) über den Schaltverstärker (11) steuerbaren elektronischen Schalter (12) und einer Speiseschaltung (13) zur Erzeugung der Speisespannung für den Oszillator (10) und für den Schaltverstärker (11). Bei solchen Schaltgeräten (1) muß der Oszillator (10) nach jeder Bedämpfung und der darauf folgenden Entdämpfung wieder anschwingen. Die Zeit, die der Oszillator (10) braucht, um vom nicht-schwingenden Zustand in den schwingenden Zustand zu kommen, die Anschwingzeit, ist ein Kriterium für die maximale Schaltfrequenz, die ein solches Schaltgerät (1) zuläßt.

Um bei Schaltgeräten (1) der in Rede stehenden Art die Anschwingzeit des Oszillators (10) zu reduzieren, ist ein Anschwinggenerator (14) vorgesehen, der eine die Oszillatorfrequenz enthaltende Anschwingspannung erzeugt, die in den Oszillator (10) eingekoppelt ist. Erfindungsgemäß wird also dem Oszillator (10) für das Anschwingen eine Anschwinghilfe zur Verfügung gestellt, die in Form der Anschwingspannung unmittelbar nach jeder Entdämpfung des Oszillators (10) zur Verfügung steht.

Fig.1

Die Erfindung betrifft ein elektronisches, berührungslos arbeitendes Schaltgerät, mit einem von außen beeinflußbaren Oszillator, ggf. einem Schaltverstärker, einem von dem Oszillator - ggf. über den Schaltverstärker - steuerbaren elektronischen Schalter, z. B. einem Transistor, einem Thyristor oder
einem Triac, und ggf. einer Speiseschaltung zur Erzeugung der Speisespannung
für den Oszillator und ggf. für den Schaltverstärker.

Elektronische Schaltgeräte der zuvor beschriebenen Art, die also kontaktlos
ausgeführt sind, werden in zunehmendem Maße anstelle von elektrischen, mechanisch
betätigten Schaltgeräten, die kontaktbehaftet ausgeführt sind, in elektrischen
Meß-, Steuer- und Regelkreisen verwendet. Hinsichtlich der Beeinflussung des
Oszillators wird dabei zwischen induktiver und kapazitiver Beeinflussung unterschieden. Bei elektronischen, berührungslos arbeitenden Schaltgeräten der eingangs beschriebenen Art mit induktiver Beeinflussung des Oszillators gilt für
den Oszillator, solange ein Metallteil einen vorgegebenen Abstand noch nicht
erreicht hat, $K \cdot V = 1$ mit $K$ = Rückkopplungsfaktor und $V$ = Verstärkungsfaktor
des Oszillators, d. h. der Oszillator schwingt. Erreicht das entsprechende Metallteil den vorgeschriebenen Abstand, so führt die zunehmende Bedämpfung des
Oszillators zu einer Verringerung des Verstärkungsfaktors $V$, so daß $K \cdot V < 1$
wird, d. h. der Oszillator hört auf zu schwingen. Bei elektronischen, berührungslos arbeitenden Schaltgeräten der eingangs beschriebenen Art mit kapazitiver
Beeinflussung des Oszillators gilt für den Oszillator, solange ein Ansprechkörper die Kapazität zwischen einer Ansprechelektrode und einer Gegenelektrode noch
nicht hinreichend vergrößert hat, also einen vorgegebenen Abstand noch nicht erreicht hat, $K \cdot V < 1$, d. h. der Oszillator schwingt nicht. Erreicht der Ansprechkörper den vorgegebenen Abstand, so führt die steigende Kapazität zwischen
der Ansprechelektrode und der Gegenelektrode zu einer Vergrößerung des Rückkopplungsfaktors $K$, so daß $K \cdot V = 1$ wird, d. h. der Oszillator beginnt zu schwingen.
Bei beiden Ausführungsformen wird abhängig von den unterschiedlichen Zuständen
des Oszillators der elektronische Schalter, z. B. ein Transistor, ein Thyristor
oder ein Triac, gesteuert.

Elektronische, berührungslos arbeitende Schaltgeräte sind anfangs mit einer
Reihe von Problemen behaftet gewesen, - gemessen an elektrischen, mechanisch
betätigten Schaltgeräten, nämlich u. a. mit den Problemen "Erzeugung einer
Speisespannung für den Oszillator und ggf. für den Schaltverstärker", "Ausbildung des Oszillators", "Ausbildung des Schaltverstärkers", "Einschaltimpulsverhinderung", "Kurzschlußfestigkeit". Mit diesen Problemen und deren Lösungen
(und mit anderen bei elektronischen, berührungslos arbeitenden Schaltgeräten
relevanten Problemen und deren Lösungen) befassen sich z. B. die deutschen
Offenlegungsschriften bzw. Auslegeschriften bzw. Patentschriften 19 51 137,
19 66 178, 19 66 213, 2o 36 84o, 21 27 956, 22 o3 o38, 22 o3 o39, 22 o3 o4o,
22 o3 9o6, 23 3o 233, 23 31 732, 23 56 49o, 26 13 423, 26 16 265, 26 16 773,
26 28 427, 27 11 877, 27 44 785, 29 43 911, 3o o4 829, 3o 38 1o2, 3o 38 141
und 3o 38 692.

Bei elektronischen, berührungslos arbeitenden Schaltgeräten der in Rede stehenden Art muß der Oszillator nach jeder Bedämpfung, wenn also der Oszillator zu
schwingen aufgehört hat, und der darauf folgenden Entdämpfung wieder anschwingen. (Bedämpfung und Entdämpfung gilt bei Schaltgeräten der in Rede stehenden
Art mit induktiver Beeinflussung des Oszillators; entsprechendes gilt aber auch
bei Schaltgeräten mit kapazitiver Beeinflussung des Oszillators.) Die Zeit, die
der Oszillator braucht, um vom nicht-schwingenden Zustand in den schwingenden
Zustand zu kommen, und zwar bis zu dem Zeitpunkt, bis die Oszillatorspannung
so groß ist, daß ein z. B. vorgesehener Schaltverstärker anspricht, die Anschwingzeit, ist ein Kriterium für die maximale Schaltfrequenz, die ein solches
Schaltgerät zuläßt; je länger die Anschwingzeit ist, desto niedriger ist die
maximale Schaltfrequenz.

Der Erfindung liegt nun die Aufgabe zugrunde, Schaltgeräte der in Rede stehenden
Art hinsichtlich der maximalen Schaltfrequenz zu verbessern, also anzugeben, wie
bei solchen Schaltgeräten die Anschwingzeit des Oszillators reduziert werden
kann.

Das erfindungsgemäße elektronische, berührungslos arbeitende Schaltgerät, bei dem die zuvor hergeleitete Aufgabe gelöst ist, ist zunächst und im wesentlichen dadurch gekennzeichnet, daß ein Anschwinggenerator vorgesehen ist, der Anschwinggenerator eine die Oszillatorfrequenz enthaltende Anschwingspannung erzeugt und die Anschwingspannung in den Oszillator eingekoppelt ist.

Der Lehre der Erfindung liegen folgende Überlegungen zugrunde:

Jeder Oszillator "lebt" beim Anschwingen davon, daß er gleichsam angestoßen wird, sei es durch eigenes Rauschen, sei es durch externe Einflüsse. Je mehr elektrische Energie nun einem Oszillator zur Verfügung steht, desto eher kommt er zum Anschwingen, desto kürzer ist also die Anschwingzeit.

Nun gibt es elektronische, berührungslos arbeitende Schaltgeräte der in Rede stehenden Art, die nur zwei Außenleiter benötigen, die also über insgesamt nur zwei Außenleiter einerseits an eine Spannungsquelle und andererseits an einen Verbraucher anschließbar sind. Insbesondere bei solchen Schaltgeräten wird verlangt, daß die Schaltgeräte selbst nur wenig elektrische Energie benötigen, - damit sie weitgehend elektrischen, mechanisch betätigten Schaltgeräten entsprechen, die ja ohne elektrische Energie auskommen; elektronische, berührungslos arbeitende Schaltgeräte mit nur zwei Außenleitern sollen im geöffneten Zustand nur einen minimalen Reststrom aufnehmen und im geschlossenen Zustand nur einen geringen Spannungsabfall aufweisen. Also wird den Oszillatoren solcher Schaltgeräte nur die absolut nötige elektrische Energie zur Verfügung gestellt, - woraus relativ lange Anschwingzeiten resultieren.

(Das zuvor erläuterte Problem kann auch dann relevant sein, wenn es um elektronische, berührungslos arbeitende Schaltgeräte geht, die drei Außenleiter benötigen, deren Oszillatoren also eigentlich wesentlich mehr elektrische Energie zur Verfügung gestellt werden kann, als dies bei Schaltgeräten mit nur zwei Außenleitern möglich ist, - nämlich dann, wenn aus Rationalisierungsgründen für Schaltgeräte mit zwei Außenleitern und für Schaltgeräte mit drei Außenleitern die gleichen Oszillatoren verwendet werden sollen, z. B. in Form von integrierten Schaltkreisen.)

Die allgemeine Lehre der Erfindung besteht nun darin, bei einem elektronischen, berührungslos arbeitenden Schaltgerät der in Rede stehenden Art dem Oszillator für das Anschwingen gleichsam eine Anschwinghilfe zur Verfügung zu stellen. Diese Anschwinghilfe steht erfindungsgemäß in Form der vom Anschwinggenerator erzeugten Anschwingspannung unmittelbar nach jeder Entdämpfung des Oszillators zur Verfügung, so daß der Oszillator nicht zu warten braucht, bis er - zufällig - angestoßen wird.

Im einzelnen gibt es verschiedene Möglichkeiten, das erfindungsgemäße elektronische, berührungslos arbeitende Schaltgerät auszugestalten und weiterzubilden, was im folgenden nur beispielhaft erläutert werden soll.

Wie weiter oben ausgeführt, muß der bei einem elektronischen, berührungslos arbeitenden Schaltgerät der in Rede stehenden Art erfindungsgemäß vorgesehene Anschwinggenerator eine Anschwingspannung erzeugen, die die Oszillatorfrequenz enthält. Folglich kann der Anschwinggenerator als Rauschgenerator ausgeführt sein. Vorzugsweise ist der Anschwinggenerator jedoch als Funktionsgenerator ausgeführt, der eine sägezahnförmige oder eine rechteckförmige Anschwingspannung erzeugt.

Nach einer weiteren Lehre der Erfindung, der auch losgelöst von ihrer Anwendung bei einem elektronischen, berührungslos arbeitenden Schaltgerät der in Rede stehenden Art erfindungswesentliche Bedeutung zukommt, weist der als Funktionsgenerator ausgeführte Anschwinggenerator einen Konstantstromgenerator, einen von dem Konstantstromgenerator eingespeisten Ladekondensator und einen dem Ladekondensator mit seiner Kollektor-Emitter-Strecke parallelgeschalteten Entladetransistor auf; anstelle der Kollektor-Emitter-Strecke eines Entladetransistors kann dem Ladekondensator auch ein anderer Entladeschalter parallelgeschaltet sein.

Bei dem erfindungsgemäßen elektronischen, berührungslos arbeitenden Schaltgerät kommt die zuvor erläuterte Anschwinghilfe nur nach der Entdämpfung des Oszillators zum Tragen. Folglich empfiehlt es sich, dafür zu sorgen, daß der erfindungsgemäß vorgesehene Anschwinggenerator nur dann die Anschwingspannung erzeugt, wenn sie von dem Oszillator ausgenutzt werden kann, also nach der Entdämpfung

- 6 -

des Oszillators. Das kann bei der zuvor beschriebenen bevorzugten Ausführungsform des als Funktionsgenerator ausgeführten Anschwinggenerators dadurch realisiert sein, daß der Basis-Emitter-Strecke des Entladetransistors die Kollektor-
Emitter-Strecke eines bei bedämpftem Oszillator durchgesteuerten Hilfstransistors
parallelgeschaltet ist. Anstelle der Kollektor-Emitter-Strecke eines bei bedämpftem Oszillator durchgesteuerten Hilfstransistors kann auch ein anderer bei bedämpftem Oszillator leitender Hilfsschalter vorgesehen sein.

Zur Lehre der Erfindung gehört, daß die von dem erfindungsgemäß vorgesehenen
Anschwinggenerator erzeugte Anschwingspannung in den Oszillator eingekoppelt ist,
so daß die Anschwingspannung das Anschwingen des Oszillators initiieren kann.
Dieses Einkoppeln der Anschwingspannung in den Oszillator muß "schwingkreisgerecht" erfolgen. Weist der Oszillator, wie üblich, einen Parallelschwingkreis
auf, dann sollte der Anschwinggenerator lose, d. h. hochohmig an den Oszillator
angekoppelt sein. Z. B. kann der Anschwinggenerator über einen Koppelkondensator
(mit relativ geringer Kapazität) an den Oszillator angeschlossen sein.

Bei elektronischen, berührungslos arbeitenden Schaltgeräten der in Rede stehenden Art weist der Oszillator häufig einen in Emitterschaltung betriebenen Verstärkertransistor auf. Dann kann der Anschwinggenerator, vorzugsweise über den
zuvor angesprochenen Koppelkondensator, an den Kollektor, den Emitter oder die
Basis des Verstärkertransistors angeschlossen sein.

Im folgenden wird die Erfindung anhand einer lediglich ein Ausführungsbeispiel
darstellenden Zeichnung ausführlicher erläutert; es zeigt

Fig. 1 ein Blockschaltbild einer bevorzugten Ausführungsform eines erfindungsgemäßen elektronischen, berührungslos arbeitenden Schaltgerätes und

Fig. 2 eine bevorzugte Ausführungsform des Anschwinggenerators des Schaltgerätes nach Fig. 1.

- 7 -

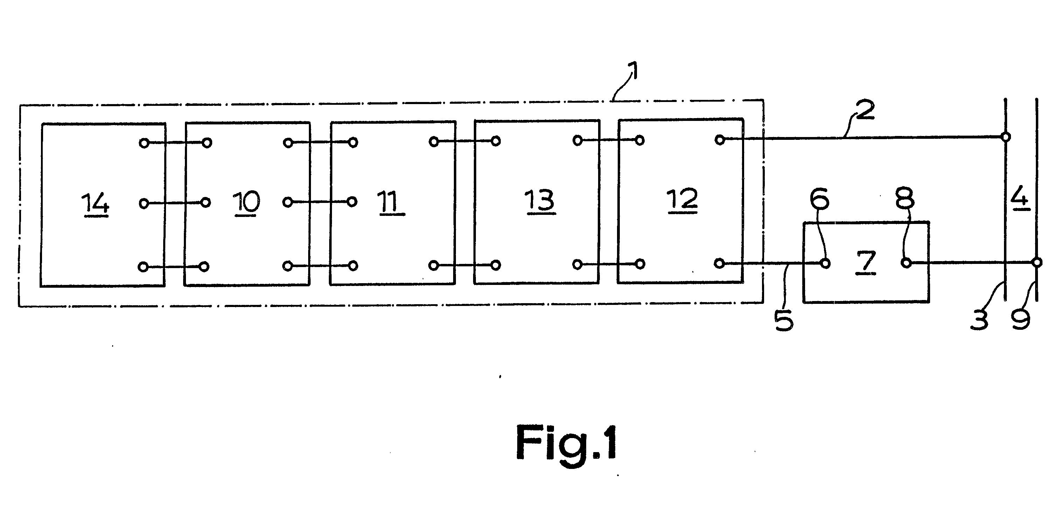

Das in Fig. 1 in Form .eines Blockschaltbildes dargestellte elektronische
Schaltgerät 1 arbeitet berührungslos, d. h. es spricht auf ein sich annäherndes,
in den Figuren nicht dargestelltes Metallteil an, und ist über einen Außenleiter 2 mit einem Pol 3 einer Spannungsquelle 4 und nur über einen weiteren Außenleiter 5 mit einem Anschluß 6 eines Verbrauchers verbindbar, wobei der andere
Anschluß 8 des Verbrauchers an den anderen Pol der Spannungsquelle 4 angeschlossen ist. Mit anderen Worten ist das dargestellte elektronische Schaltgerät 1
über insgesamt nur zwei Außenleiter 2, 5 einerseits an die Spannungsquelle 4
und andererseits an den Verbraucher 7 anschließbar.

In seinem grundsätzlichen Aufbau besteht das in Fig. 1 dargestellte elektronische, d. h. kontaktlose Schaltgerät 1 aus einem von außen, nämlich durch das
nicht dargestellte Metallteil beeinflußbaren Oszillator 1o, aus einem dem Oszillator 1o nachgeschalteten Schaltverstärker 11, aus einem von dem Oszillator 1o
über den Schaltverstärker 11 steuerbaren elektronischen Schalter 12, nämlich
einem Transistor, und aus einer Speiseschaltung 13 zur Erzeugung der Speisespannung für den Oszillator 1o und den Schaltverstärker 11.

Wie die Figuren zeigen, ist erfindungsgemäß ein Anschwinggenerator 14 vorgesehen
der eine die Oszillatorfrequenz enthaltende Anschwingspannung erzeugt, die in
den Oszillator 1o eingekoppelt ist.

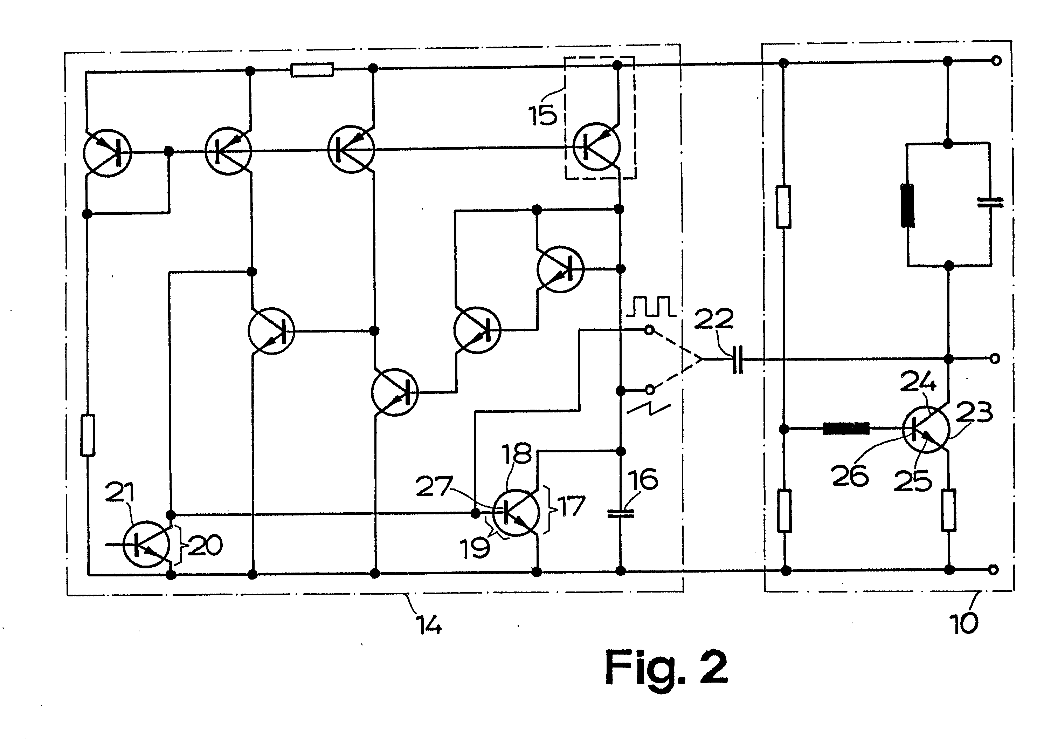

Im dargestellten Ausführungsbeispiel ist der Anschwinggenerator 14 als Funktions
generator ausgeführt, der sowohl eine sägezahnförmige Anschwingspannung als auch
eine rechteckförmige Anschwingspannung erzeugt. Es besteht also die Möglichkeit,
entweder die sägezahnförmige Anschwingspannung oder die rechteckförmige Anschwin
.spannung in den Oszillator 1o einzukoppeln, was in Fig. 2 alternativ dargestellt
ist.

Wie die Fig. 2 zeigt, weist im dargestellten Ausführungsbeispiel der als
Funktionsgenerator ausgeführte Anschwinggenerator 14 einen Konstantstromgenerator 15, einen von dem Konstantstromgenerator 15 eingespeisten Ladekondensator 16
und einen dem Ladekondensator 16 mit seiner Kollektor-Emitter-Strecke 17 paralle
geschalteten Entladetransistor 18 auf. Der Basis-Emitter-Strecke 19 des Entlade-

- 8 -

transistors 18 ist die Kollektor-Emitter-Strecke 2o eines bei bedämpftem Oszillator 1o durchgesteuerten Hilfstransistors 21 parallelgeschaltet.

Der zuvor erläuterte, als Funktionsgenerator ausgeführte Anschwinggenerator 14
ist über einen Koppelkondenstor 22 an den Oszillator 1o angeschlossen.

Wie in der Fig. 2 angedeutet, weist der Oszillator 1o einen in Emitterschaltung
betriebenen Verstärkertransistor 23 auf und ist der Anschwinggenerator 14
- über den Koppelkondensator 22 - an den Kollektor 24 des Verstärkertransistors
23 angeschlossen. (Es besteht auch die Möglichkeit, den Anschwinggenerator 24
an den Emitter 25 oder an die Basis 26 des Verstärkertransistors 23 anzuschließen.)

Die Funktionsweise des in Fig. 2 dargestellten, als Funktionsgenerator ausgeführten Anschwinggenerators 14 ist denkbar einfach:

Der Ladekondensator 16 wird von dem Konstantstromgenerator 15 mit einem konstanten Strom versorgt, so daß die Spannung am Ladekondensator 16 zeitlinear
ansteigt. Hat die Spannung am Ladekondensator 16 einen bestimmten Wert erreicht,
im vorliegenden Fall etwa 1,8 V, so wird der Entladetransistor 18 leitend und
der Ladekondensator 16 über die Kollektor-Emitter-Strecke 17 des Entladetransistors 18 entladen. Wie in der Fig. 2 angedeutet, steht am Ladekondensator 16
eine sägezahnförmige Anschwingspannung an, während von der Basis 27 des Entladetransistors 18 eine rechteckförmige Anschwingspannung abgenommen werden
kann.

Ist der in Fig. 2 dargestellte Hilfstransistor 21 durchgesteuert, was bei bedämpftem Oszillator 1o der Fall ist, dann wird durch den Anschwinggenerator 14
keine Anschwingspannung erzeugt, weil dann die Basis-Emitter-Strecke 19 des
Entladetransistors 18 über die Kollektor-Emitter-Strecke 2o des Hilfstransistors
21 kurzgeschlossen ist.

Patentansprüche:

1. Elektronisches, berührungslos arbeitendes Schaltgerät, mit einem von außen beeinflußbaren Oszillator, ggf. einem Schaltverstärker, einem von dem Oszillator - ggf. über den Schaltverstärker - steuerbaren elektronischen Schalter, z. B. einem Transistor, einem Thyristor oder einem Triac, und ggf. einer Speiseschaltung zur Erzeugung der Speisespannung für den Oszillator und ggf. für den Schaltverstärker, d a d u r c h   g e k e n n z e i c h n e t , daß ein Anschwinggenerator (14) vorgesehen ist, der Anschwinggenerator (14) eine die Oszillatorfrequenz enthaltende Anschwingspannung erzeugt und die Anschwingspannung in den Oszillator (1o) eingekoppelt ist.

2. Elektronisches Schaltgerät nach Anspruch 1, dadurch gekennzeichnet, daß der Anschwinggenerator als Rauschgenerator ausgeführt ist.

3. Elektronisches Schaltgerät nach Anspruch 1, dadurch gekennzeichnet, daß der Anschwinggenerator (14) als Funktionsgenerator ausgeführt ist und eine sägezahnförmige Anschwingspannung erzeugt.

4. Elektronisches Schaltgerät nach Anspruch 1, dadurch gekennzeichnet, daß der Anschwinggenerator (14) als Funktionsgenerator ausgeführt ist und eine rechteckförmige Anschwingspannung erzeugt.

5. Elektronisches Schaltgerät nach Anspruch 3 oder 4, dadurch gekennzeichnet, daß der als Funktionsgenerator ausgeführte Anschwinggenerator (14) einen Konstantstromgenerator (15), einen von dem Konstantstromgenerator (15) eingespeisten Ladekondensator (16) und einen dem Ladekondensator (16) mit seiner Kollektor-Emitter-Strecke (17) parallelgeschalteten Entladetransistor (18) aufweist.

6. Elektronisches Schaltgerät nach Anspruch 5, dadurch gekennzeichnet, daß der Basis-Emitter-Strecke (19) des Entladetransistors (18) die Kollektor-Emitter-Strecke (2o) eines bei bedämpftem Oszillator (1o) durchgesteuerten Hilfstransistors (21) parallelgeschaltet ist.

- 1 -

0065649

7. Elektronisches Schaltgerät nach einem der Ansprüche 1 bis 6, dadurch gekennzeichnet, daß der Anschwinggenerator (14) über einen Koppelkondensator (22)
an den Oszillator (1o) angeschlossen ist.

8. Elektronisches Schaltgerät nach einem der Ansprüche 1 bis 7, wobei der Oszillator einen in Emitterschaltung betriebenen Verstärkertransistor aufweist, dadurch gekennzeichnet, daß der Anschwinggenerator (14) an den Kollektor (24),
den Emitter oder die Basis des Verstärkertransistors (23) angeschlossen ist.

- 2 -

**Fig.1**

Fig. 2

0065649

Europäisches
Patentamt

**EUROPÄISCHER RECHERCHENBERICHT**

| | **EINSCHLÄGIGE DOKUMENTE** | | **KLASSIFIKATION DER ANMELDUNG (Int Cl )** |
|---|---|---|---|
| Kategorie | Kennzeichnung des Dokuments mit Angabe, soweit erforderlich, der maßgeblichen Teile | betrifft Anspruch | |
| D,Y | <u>DE - B2 - 2 711 877</u> (R. BUCK)<br>* Spalte 8, Zeilen 50 bis 59; Fig. 1,<br>    Positionen 10, 11, 13, 14 * | 1 | H 03 K 17/945<br>H 03 B 5/06 |
| | -- | | |
| Y | <u>US - A - 3 247 466</u> (R.M. MAYER)<br>* Spalte 1, Zeilen 43 bis 54; Fig. * | 1 | |
| | -- | | |
| A | <u>DE - A1 - 2 915 110</u> (PEPPERL & FUCHS<br>GMBH & CO. KG)<br>* Ansprüche 1, 8; Seite 12, Zeile 28 bis<br>    Seite 13, Zeile 25; Fig. 2 * | | **RECHERCHIERTE SACHGEBIETE (Int Cl )**<br><br>G 08 G 1/01<br>G 08 G 1/02<br>G 01 V 3/08<br>H 03 B 5/06<br>H 03 K 17/945<br>H 03 K 17/95<br>H 03 K 17/955<br>H 03 K 17/96 |

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

X  Der vorliegende Recherchenbericht wurde für alle Patentansprüche erstellt.

| Recherchenort | Abschlußdatum der Recherche | Prüfer |
|---|---|---|
| Berlin | 30-06-1982 | ARENDT |

EPA form 1503.1   06.78